# EUROPÄISCHE PATENTSCHRIFT

(11) **EP 1 895 653 B1**
(45) Veröffentlichungstag und Bekanntmachung des Hinweises auf die Patenterteilung: **07.09.2011**
(21) Anmeldenummer: 07013558.7
(22) Anmeldetag: 11.07.2007
(51) Int. Cl.: H03B 11/02

(54) **Verfahren und Einrichtung zum Erzeugen und Abstrahlen eines Hochleistungs-Mikrowellenpulses**
Method and device for creating and emitting a high performance microwave impulse
Procédé et dispositif destinés à la production et à l'émission d'une impulsion à micro-ondes haute puissance

(30) Priorität: 19.07.2006 DE 102006033374
(43) Veröffentlichungstag der Anmeldung: 05.03.2008
(73) Patentinhaber: Diehl BGT Defence GmbH & Co.KG, 88662 Überlingen (DE)
(72) Erfinder: Staines, Geoffrey, Dr., San Diego, CA 92111 (US)
(74) Vertreter: Diehl Patentabteilung

(56) Entgegenhaltungen:
- US-A- 3 011 051
- US-A- 4 070 636

## Beschreibung

Die Erfindung betrifft ein Verfahren bzw. eine Einrichtung gemäß dem Oberbegriff des jeweiligen Hauptanspruches.

Beispielsweise in der DE 103 19 475 A1 ist ein Generator zum Erzeugen und Abstrahlen von Impulsenergie im Mikrowellenspektrum (allgemein bezeichnet als HPM = High Power Microwaves) beschrieben, deren breitbandig hohe Energiedichte geeignet ist, in der Umgebung betriebenen Funkverkehr zumindest zu beeinträchtigen und elektronische Schaltungen insbesondere eingangsseitig zu stören oder gar zu zerstören. Dafür arbeitet der Mikrowellengenerator auf eine ihm angepasste Antennenstruktur zur impulsförmigen Energieabstrahlung. Die Anregung des Mikrowellengenerators erfolgt aus einer Ladeschaltung mit einer Stromquelle, bei mobilen Geräten einem Akkumulator, und mit einem elektronischen Spannungswandler über einen Marxschen Stoßspannungsgenerator, wie er etwa in der DE 10 2004 020 342 A1 näher beschrieben ist. Seine Funktion beruht darauf, einen Stapel von Kondensatoren parallel aufzuladen und dann unter Umschaltung auf eine Serienschaltung über einen Verbraucher zu entladen, bei dem es sich dort um den Mikrowellengenerator handelt. Das Umschalten auf die Serienschaltung zur Spannungsvervielfachung gemäß der Anzahl der im Marxschen Stoßspannungsgenerator zuvor parallel aufgeladenen Kondensatoren erfolgt durch Ansprechen und Durchzünden von Funkenstrecken. Apparativ lässt sich eine solche autark betreibbare HPM-Einrichtung in einem Behältnis von der Größenordnung einer größeren Aktentasche unterbringen, in dem die Ladeschaltung, der daraus aufzuladende Marxsche Stoßspannungsgenerator und der von diesem gespeiste Mikrowellengenerator samt angeflanschtem Antennenkonus in drei etwa gleich großen Apparategruppen nebeneinander angeordnet sind.

Aus der US 3,011,051 ist eine Vorrichtung zum Erzeugen und Übertragen von Hochleistungs-Radiowellenpulsen bekannt, welche einen Schwingungskreis umfasst, welcher aus Kondensatoren, Induktivitäten, Funkenentladungstrecken und Ladewiderständen aufgebaut ist, welche in einer kreisförmigen Grundstruktur angeordnet sind.

Der Erfindung liegt die technische Problemstellung zugrunde, ein Verfahren und eine Einrichtung gattungsgemäßer Art anzugeben, die im etwa gleichen HPM-Leistungsspektrum mit wesentlich geringerem Raum- und Schaltungsbedarf auskommen.

Diese Aufgabe ist gemäß den in den beiden Hauptansprüchen angegebenen wesentlichen Merkmalen gelöst. Danach wird auf einen dem Marxschen Stoßspannungsgenerator nachgeschalteten Mikrowellengenerator mit Antenne zum Erzeugen und Abstrahlen der Impulsenergie völlig verzichtet und nun statt dessen die Mikrowellenenergie schon vom Marxschen Stoßspannungsgenerator selbst erzeugt und abgestrahlt, der dafür als Resonator und kapazitiv gespeister Hertzscher Dipol mit großen Streukapazitäten wirkt. Das erspart den Aufwand für Erstellung eines separaten antennenbestückten Mikrowellengenerators mit seinen zusätzlichen Funkenstrecken und das reduziert dadurch den apparativen Raumbedarf auf etwa zwei Drittel des bisherigen.

Der Marxsche Stoßspannungsgenerator wird nachfolgend einer Übung der Praxis folgend vereinfacht als Marx-Generator bezeichnet. Um diesen Marx-Generator selbst möglichst effektiv als Mikrowellenstrahler einsetzen zu können, ist seine Kaskade der Marx- Kondensatoren im Interesse kurzer Ladezeitkonstanten mit vergleichsweise kleinen Kondensatoren aufgebaut und die effektive Ausgangskapazität der Ladeschaltung dagegen klein gehalten, etwa im Bereich der Größenordnung von 2% (nämlich typisch ca. 20 pF bei Marx-Kondensatoren in der Größenordnung von je 1000 pF).

Zweckmäßigerweise wird die, ohnehin unvermeidliche aber hier für das Schwingungsverhalten benötigte, Streukapazität des Marx-Generators durch elektrisch leitende Platten an den beiden Stirnenden der Kondensatorsäule künstlich vergrößert. Ein Plattendurchmesser von 20 cm erbringt dabei eine Erhöhung der Streukapazität des Marx-Generators um ca. 10 pF.

Eine weitere Verbesserung des hochfrequenten Schwingungsverhaltens eines erfindungsgemäß direkt als Mikrowellengenerator eingesetzten Marx-Generators ergibt sich aus einer Verringerung der Ladewiderstände vor den einzelnen Marx-Kondensatoren, weil dadurch der Entladevorgang der Serienschaltung beschleunigt wird. Weil hier nur geringe Ströme fließen, sind als hochspannungsfeste Widerstände handelsübliche mechanisch hoch beanspruchbare elektrisch leitende Kunststoffe zu bevorzugen.

Von besonderem Vorteil für ein steil einsetzendes Schwingungsverhalten ist die Verwendung von extern triggerbaren Funkenstrecken-Schaltern bei jeder der Kondensatorstufen des Marx-Generators. Dadurch wird vermieden, dass eine Funkenstrecke erst durchschaltet, weil die vorangegangene Stufe der Kondensatorsäule durchgeschaltet hat, was zu typisch ca. 1 nsec Schaltverzögerung pro Stufe führen würde. Das zentrale Triggern aller Funkenstrecken-Schalter gleichzeitig stellt dagegen sicher, dass infolge gleichzeitigen Umschaltens aller Kondensatorstufen von Parallelladung auf Reihenentladung praktisch noch kein Ladungsverlust über deren einzelnen Ladewiderstände eintritt, sondern nun tatsächlich unmittelbar die Gesamtspannung aus der Serienschaltung aller Kondensatorstufen mit den jeweils dazwischen gelegenen, durchgezündeten Funkenstrecken zum Anregen des hochfrequenten Resonanzeffektes über der Kondensatorsäule ansteht, was zum Abstrahlen eines steil einsetzenden, energiereichen Mikrowellenimpulses direkt vom Marx-Generator führt.

Besonders zweckmäßig ist es in diesem Zusammenhang, Funkenstrecken-Schalter mit jeweils einer dritten Elektrode als Triggerelektrode einzusetzen. Diese Triggerelektroden können alle zusammengeschaltet und über einen Vorwiderstand auf Massepotential gelegt sein, während der Kondensatorstapel bipolar (symmetrisch zum Massepotential) aufgeladen wird. Wenn die erste der Funkenstrecken durchzündet, liegen deshalb die Triggerelektroden aller anderen Funkenstrecken auf einem der beiden Ladepotentiale gegenüber Massepotential und zünden deshalb sofort auch alle durch. Je mehr derartiger Schaltvorgänge schon stattgefunden haben, desto größer ist die Potentialdifferenz über den noch verbliebenen Schaltstrecken, so dass diese nun noch zuverlässiger ansprechen und rascher durchzünden.

Die elektrisch zusammengeschalteten Triggerelektroden können aber auch alle gemeinsam aus einem dafür gesondert betriebenen Hochspannungs-Pulsgenerator angesteuert werden. Dessen Triggerimpuls würde bei einer Serienschaltung der Triggerelektroden über die gesamte Länge des Stapels der gerade aufgeladenen Kondensatoren durchlaufen, um diese nun zum Entladen in Serie zu schalten - allerdings mit einer Laufzeit in der Größenordnung von typisch einer Nanosekunde über eine Weglänge in der Größenordnung von 30 cm. Die Schaltsynchronität kann deshalb noch verbessert werden, wenn die Triggerpulseinspeisung mehrfach symmetrisch zu den Triggerelektroden erfolgt, so daß über diese Auffächerung direkt zu den Funkenstrecken hin die wirksamen Laufzeiten der Triggerpulse signifikant verkürzt werden.

Jedenfalls wird erfindungsgemäß das Erzeugen und Abstrahlen hochenergetischer Mikrowellenpulse nun mittels einer wesentlich kompakter bauenden Einrichtung ermöglicht, indem der Marx-Generator mit seiner Kondensator-Säule, die herkömmlicherweise eigens einen Mikrowellengenerator mit angepasster Antennengeometrie speist, nun - unter Verzicht auf den Mikrowellengenerator und seine Antenne - unmittelbar selbst auch als Resonator und zugleich als Hertzscher Antennendipol zum Abstrahlen der Hochleistungs-Mikrowellenpulse eingesetzt wird. Das Schwingungsverhalten des Marx-Generators kann insbesondere durch getriggerte Funkenstrecken für das Umschalten zum Entladen der Kondensatoren und durch stirnseitige Platten zum Erhöhen der Streukapazitäten der Kondensatoranordnung apparativ optimiert werden.

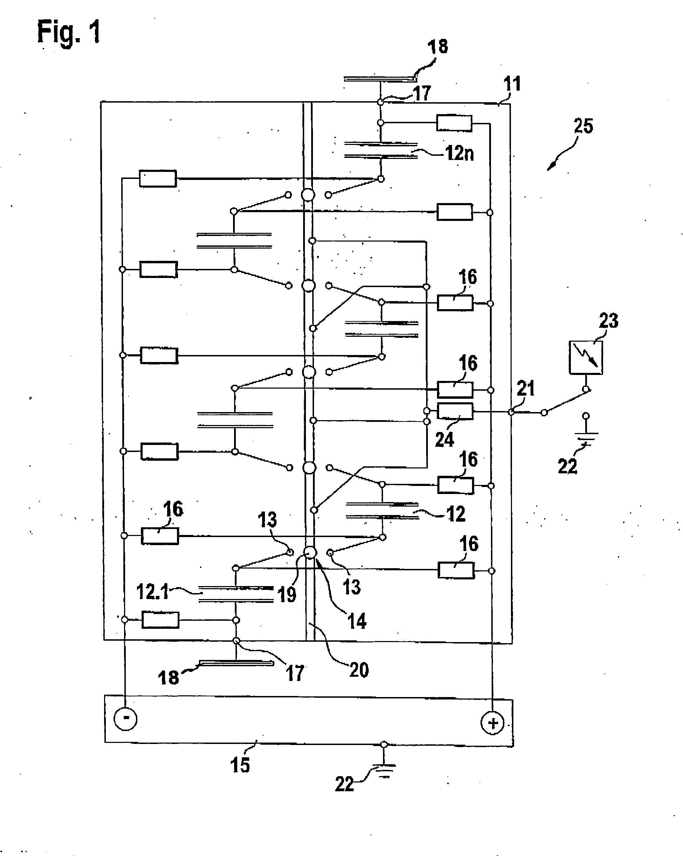

Zusätzliche Weiterbildungen und Alternativen der Erfindung ergeben sich aus den weiteren Ansprüchen und aus nachstehender Beschreibung eines in der Zeichnung nicht maßstabsgerecht auf das Funktionswesentliche abstrahiert skizzierten bevorzugten Realisierungsbeispiels zur erfindungsgemäßen Lösung. Die einzige Figur der Zeichnung zeigt nach Art eines Schaltbildes den prinzipiellen Aufbau eines unmittelbar als Mikrowellengenerator abstrahlenden Marx-Generators.

Der hier weiterhin einfach als Marx-Generator 11 bezeichnete Marxsche Stoßspannungsgenerator weist eine Säule aus n Stück relativ großvolumigen Kondensatoren 12 (12.1 bis 12.n) auf, die im Interesse gedrängten Aufbaus wie skizziert im Zickzack seitlich auf Lücke versetzt zu einer kurzen Säule gestapelt sind. In Serie mit je zwei einander zugeordneten Kondensatoren 12-12 geschaltet ist ein Hochspannungsschalter in Form der beiden aufeinander zu orientierten Elektroden 13-13 einer Funkenstrecke 14.

Aus einer Gleichstrom-Ladeschaltung 15 werden die Kondensatoren 12 jeder mit einer vorzugsweise bipolaren Hochspannung in der Größenordnung von einigen 10 kVolt bei einem Ladestrom in der Größenordnung eines mAmpere parallel aufgeladen. Jedem Kondensator 12 ist in seinen beiden Ladewegen je ein Entkopplungswiderstand 16 vorgeschaltet, der, bei Durchschalten der Funkenstrecke 14 zum benachbarten Kondensator 12, einen Kurzschluss über diese Ladewege verhindert.

An die Ausgänge 17 auf den Stirnseiten des Generators 11 mit seiner Kondensator-Säule 12-12 sind Platten 19 aus elektrisch leitendem Material oder mit leitender Beschichtung zum Erhöhen der Streukapazität des Generators 11 angeschlossen, die entgegen der Prinzipdarstellung auch direkt auf den Stirnflächen des Gehäuses des Marx-Generators 11 isoliert angeordnet sein können.

Alle Funkenstrecken 14 weisen zwischen ihren Elektroden 13-13 als dritte eine Triggerelektrode 19 zum Fördern des Durchschaltens der jeweiligen Funkenstrecke 14 und somit zum möglichst gleichzeitigen Einsetzen der Serien-Entladung über alle Kondensatorstufen 12-12 auf. Die Funkenstrecken 14 sind im Generator 11 vorzugsweise derart positioniert, dass die Triggerelektroden 19 alle in einer Ebene liegen. Deshalb können sie, mit einem dem mechanischen Aufbau der Funkenstrecken 14 geometrisch entsprechenden Muster, in einer dünnen Tafel 20 aus elektrisch (wenn auch schlecht) leitendem Kunststoff mechanisch gehaltert und dadurch zugleich elektrisch miteinander leitend verbunden sein. Diese hochohmige Zusammenschaltung der Triggerelektroden 19 verhindert Kurzschlüsse der Kondensatoren 12 über die Triggerelektroden 19 der durchgezündeten Funkenstrecken 14.

Für den Einbau und Anschluss aller Triggerelektroden 19 braucht auf diese Weise nur diese Tafel 20 im Innern des Generators 11 so angeordnet zu werden, dass die Elektroden 13-13 mit ihren jeweils angeschlossenen Kondensatoren 12 abwechselnd beiderseits einer der Triggerelektroden 19 in der Tafel 20 zu liegen kommen. Im Interesse gleicher Impulslaufzeiten zu den einzelnen Triggerelektroden 19 ist ein Triggereingang 21 räumlich symmetrisch mehrfach an die Tafel 20 angeschlossen, wie in der Zeichnung symbolisch berücksichtigt.

Der Triggereingang 21 kann, wie oben erläutert, auf Massepotential 22 gelegt oder an einen Triggergenerator 23 angeschlossen werden. Ein Entkopplungswiderstand 24 von der Verschaltungs- und Träger-Tafel 20 zum Triggereingang 21 liefert die kapazitive Zeitkonstante, die ein nennenswertes Entladen der Kondensatoren 12 über die Triggerelektroden 19 nach Massepotential 22 hin bzw. in den Triggergenerator 23 hinein vor Aufbau und Abstrahlen des HPM-Pulses verhindert.

Mit dem Triggern der Funkenstrecken 14 werden also die zuvor parallel aufgeladenen n Kondensatoren 12 (12.1 bis 12.n) alle elektrisch in Reihe geschaltet, wodurch zwischen den Ausgängen 17-17 bzw. den hier angeschlossenen Platten 18 das (fast) n-Fache der Ladespannung aus der Ladeschaltung 15 oszilliert und so der Marx-Generator 11 unmittelbar als Resonator und Hertzscher Antennendipol 25 wirkend einen Hochleistungs-Mikrowellenimpuls abstrahlt.

### Bezugszeichenliste

- 11.: Marx-Generator (mit 14 zwischen 12-12)
- 12.: Kondensatoren, n Stück gestapelt (12.1 bis 12.n)
- 13.: Elektroden (von 14)
- 14.: Funkenstrecken (zwischen 12-12)
- 15.: Ladeschaltung (für 12 parallel)
- 16.: Entkopplungswiderstände (vor 12)
- 17.: Ausgänge (von 11)
- 18.: elektrisch leitende Platten (an 17)
- 19.: Triggerelektroden (zwischen 13-13 von 14)
- 20.: elektrisch leitende Tafel (für 19)
- 21.: Triggereingang (für 19)
- 22.: Massepotential (an 21)
- 23.: Triggergenerator (an 21)
- 24.: Entkopplungswiderstand (zwischen 20 und 21)
- 25.: Antennendipol (in Form von 11)

## Patentansprüche

1. Einrichtung zum Erzeugen und Abstrahlen eines Hochleistungs-Mikrowellenpulses, wobei ein, mit aus einer Ladeschaltung (15) parallel aufgeladenen und dann über die Elektroden (13) von Funkenstrecken (14) auf Serie umschaltbaren Kondensatoren (12) ausgestatteter Marx-Generator (11) unmittelbar als Resonator und Antennendipol (24) dient,
**dadurch gekennzeichnet,**
**dass** alle Triggerelekiroden (19) in einer Ebene an einer Tafel (20) aus elektrisch leitendem Kunststoff angeordnet sind, die im Marx-Generator (11) zwischen den Funkenstrecken-Elektroden (13) gehaltert ist,
wobei die Funkenstrecken (14) mit Triggerelektroden (19) ausgestattet sind, die gemeinsam über einen Entkopplungswiderstand (24) auf Massepotential (22) gelegt sind, während die Kondensatoren (12) in Parallelschaltung an eine bipolare Hochspannungs-Ladeschaltung (15) angeschlossen sind.

2. Einrichtung zum Erzeugen und Abstrahlen eines Hochleistungs-Mikrowellenpulses, wobei ein, mit aus einer Ladeschaltung (15) parallel aufgeladenen und dann über die Elektroden (13) von Funkenstrecken (14) auf Serie umschaltbaren Kondensatoren (12) ausgestatteter Marx-Generator (11) unmittelbar als Resonator und Antennendipol (24) dient,
**dadurch gekennzeichnet,**
**dass** alle Triggerelektroden (19) in einer Ebene an einer Tafel (20) aus elektrisch leitendem Kunststoff angeordnet sind, die im Marx-Generator (11) zwischen den Funkenstreeken-Elektroden (13) gehaltert ist,
wobei die Funkenstrecken (14) mit Triggerelektroden (19) ausgestattet sind, die gemeinsam auf einen Hochspannungs-Triggergenerator (23) geschaltet sind.

3. Einrichtung nach einem der vorangehenden Ansprüche,
**dadurch gekennzeichnet,**
**dass** die Kondensatoren (12) über Entkopplungswiderstände (16) aus elektrisch leitendem Kunststoff an die Ladeschaltung (15) angeschlossen sind.

4. Einrichtung nach einem der vorangehenden Ansprüche,
**dadurch gekennzeichnet,**
**dass** der Marx-Generator (11) stirnseitig mit an den Stapel von Kondensatoren (12) angeschlossenen elektrisch leitenden Platten (18) ausgestattet ist.

## Claims

1. Device for production and emission of a high-power microwave pulse, wherein a Marx generator (11), which is equipped with capacitors (12) which are charged in parallel from a charging circuit (15) and can then be connected in series via the electrodes (13) of spark gaps (14), is used directly as a resonator and antenna dipole (24),
**characterized**
**in that** all trigger electrodes (19) are arranged on a plane on a board (20) which is composed of electrically conductive plastic and is held in the Marx generator (11) between the spark-gap electrodes (13),
wherein the spark gaps (14) are equipped with trigger electrodes (19) which are jointly connected to earth potential (22) via a decoupling resistor (24), while the capacitors (12) are connected in parallel to a bipolar high-voltage charging circuit (15).

2. Device for production and emission of a high-power microwave pulse, wherein a Marx generator (11), which is equipped with capacitors (12) which are charged in parallel from a charging circuit (15) and can then be connected in series via the electrodes (13) of spark gaps (14), is used directly as a resonator and antenna dipole (24),
**characterized**
**in that** all trigger electrodes (19) are arranged on a plane on a board (20) which is composed of electrically conductive plastic and is held in the Marx generator (11) between the spark-gap electrodes (13),
wherein the spark gaps (14) are equipped with trigger electrodes (19) which are jointly connected to a high-voltage trigger generator (23).

3. Device according to one of the preceding claims,
**characterized**
**in that** the capacitors (12) are connected to the charging circuit (15) via decoupling resistors (16) composed of electrically conductive plastic.

4. Device according to one of the preceding claims,
**characterized**
**in that**, at the end, the Marx generator (11) is equipped with electrically conductive plates (18) which are connected to the stack of capacitors (12).

## Revendications

1. Dispositif destiné à la production et à l'émission d'une impulsion à micro-ondes de haute puissance, dans lequel un générateur de Marx (11), équipé de condensateurs (12) chargés en parallèle par un circuit de charge (15) et commutables ensuite en série par les électrodes (13) des éclateurs (14), sert directement de résonateur et de dipôle d'antennes (24),
**caractérisé en ce que** toutes les électrodes de déclenchement (19) sont disposées dans un plan sur un tableau (20) de matière plastique électriquement conductrice, fixé dans le générateur de Marx (11) entre les électrodes (13) des éclateurs, dans lequel les éclateurs (14) sont pourvus d'électrodes de déclenchement (19) mises collectivement au potentiel de la masse (22) par l'intermédiaire d'une résistance de découplage (24), alors que les condensateurs (12) branchés en parallèle sont raccordés à un circuit bipolaire de charge (15) à haute tension.

2. Dispositif destiné à la production et à l'émission d'une impulsion à micro-ondes de haute puissance, dans lequel un générateur de Marx (11), équipé de condensateurs (12) chargés en parallèle par un circuit de charge (15) et commutables ensuite en série par les électrodes (13) des éclateurs (14), sert directement de résonateur et de dipôle d'antenne (24),
**caractérisé en ce que** toutes les électrodes de déclenchement (19) sont disposées dans un plan sur un tableau (20) de matière plastique électriquement conductrice, fixé dans le générateur de Marx (11) entre les électrodes (13) des éclateurs, dans lequel les éclateurs (14) sont pourvus d'électrodes de déclenchement (19) branchées collectivement à un générateur de déclenchement (23) à haute tension.

3. Dispositif selon une des revendications précédentes,
**caractérisé en ce que** les condensateurs (12) sont raccordés au circuit de charge (15) par l'intermédiaire de résistances de découplage (16) en matière plastique électriquement conductrice.

4. Dispositif selon une des revendications précédentes,
**caractérisé en ce que** le générateur de Marx (11) est pourvu sur sa face frontale de plaques (18) électriquement conductrices raccordées à la pile de condensateurs (12).
